Europäisches Patentamt

(19) European Patent Office

Office européen des brevets

(11) Publication number: **0 018 172**
**B1**

(12) **EUROPEAN PATENT SPECIFICATION**

(45) Date of publication of patent specification: **03.08.83**

(21) Application number: **80301153.5**

(22) Date of filing: **10.04.80**

(51) Int. Cl.³: **H 03 K 17/04,**
**H 03 K 17/60, G 11 C 7/06**

(54) **High speed electronic switching circuit.**

(30) Priority: **12.04.79 JP 44640/79**

(43) Date of publication of application:
**29.10.80 Bulletin 80/22**

(45) Publication of the grant of the patent:
**03.08.83 Bulletin 83/31**

(84) Designated Contracting States:
**DE GB NL**

(56) References cited:
**US - A - 3 261 988**
**US - A - 3 668 430**
**US - A - 3 702 944**
**US - A - 3 978 347**

(73) Proprietor: **FUJITSU LIMITED**
**1015, Kamikodanaka Nakahara-ku**
**Kawasaki-shi Kanagawa 211 (JP)**

(72) Inventor: **Isogai, Hideaki**
**153-2-716, Yanokuchi**
**Inagi-shi Tokyo 192-02 (JP)**

(74) Representative: **Abbott, Leonard Charles et al,**
**GILL JENNINGS & EVERY 53-64 Chancery Lane**
**London WC2A 1HN (GB)**

High speed electronic switching circuit

This invention relates to current switch circuits with improved operating speed or output voltage rise time.

In general, known current switches are constructed with emitters of first and second transistors connected in common to a constant-current supply, and with a load resistor connected between the collector of one of the transistors and a power supply, so that the collector serves as an output terminal. An input voltage is applied to the base of the first transistor, and a reference voltage (or often another input voltage) is applied to the base of the second transistor. With such a circuit, when the level of the input voltage changes to be higher or lower than the level of the reference voltage, one of the transistors is rendered non-conductive and the other one is rendered conductive.

As is known in the construction of bipolar transistors, however, the collector occupies a larger area than the emitter and forms a large capacitance with the substrate. This capacitance and the load resistance define a time constant which determines the rise speed of the collector potential. Accordingly, the rise speed of the output voltage from the low level to the high level is determined by the time constant. the collector potential is quickly switched from a high level to a low level, when the first transistor is rendered conductive, when it has a small time constant determined by a small resistance while the transistor is conductive and has a capacitance Cc. In order to increase the rise speed of the output voltage, it has heretofore been attempted to reduce the load resistance, but when using this method an increase in the current is necessary if it is desired to produce the same output voltage amplitude as before, for example for logic circuitry.

An object of the present invention is to provide an electronic current switching circuit having improved output voltage rise characteristics.

According to the present invention, there is provided an electronic current switch circuit in which the emitters of first and second transistors are connected in common to a constant-current supply, and a load resistor is connected to the collector of the first transistor to provide an output from the collector, characterised in that a third transistor in which an electric current temporarily flows to a collector circuit of the first transistor when said first transistor is rendered non-conductive, is connected in a collector circuit of the second transistor.

Embodiments of the invention will now be described, by way of example, with reference to the accompanying drawings, in which:

Fig. 1 is a circuit diagram illustrating a conventional current switch;

Figs. 2A and 2B are circuit diagrams of current switches according to the present invention;

Fig. 3 is a plan view showing the pattern of the current switch of Fig. 2A;

Figs. 4A, 4B and 4C are circuit diagrams of further current switches according to the present invention;

Fig. 5 is a cross-sectional view illustrating the construction of major portions of the current switch of Fig. 4A;

Figs. 6A and 6B are circuit diagrams of other current switches according to the present invention;

Fig. 7 is a circuit diagram of another current switch according to the present invention; and

Fig. 8 is a diagram of the application of a circuit of the present invention to an address decoder of a memory.

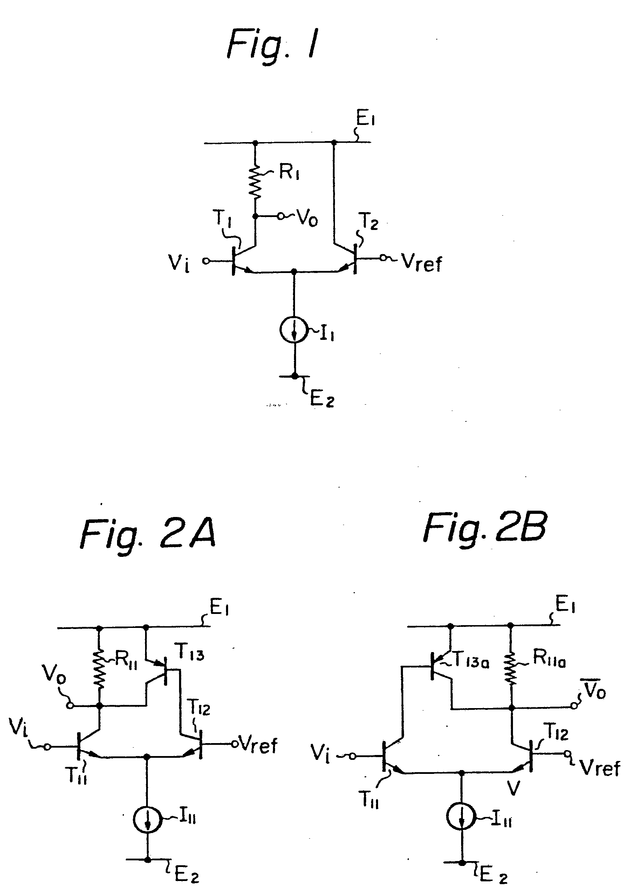

Referring to a conventional current switch shown in Fig. 1, emitters of npn-type transistors $T_1$ and $T_2$ are connected in common to a constant-current supply $I_1$, and a load resistor $R_1$ is connected between the collector of the transistor $T_1$ and a power supply line $E_1$, so that the collector serves as an output terminal. An input voltage $V_I$ is applied to the base of the transistor $T_1$, and a reference voltage $V_{ref}$ (or another input voltage) is applied to the base of the transistor $T_2$. When only one output is required, i.e. when the inverted output only is required, no load resistor is connected to the collector of the second transistor $T_2$, as shown in Fig. 1. In other words, the collector of the second transistor $T_2$ is directly connected to the power supply line $E_1$.

The current switch operates in a customary manner. Namely, when the input voltage $V_I$ changes to a high level or to a low level with respect to the reference voltage $V_{ref}$, the transistor $T_1$ is rendered conductive or non-conductive, respectively, and the transistor $T_2$ is rendered non-conductive or conductive in an opposite manner to the transistor $T_1$.

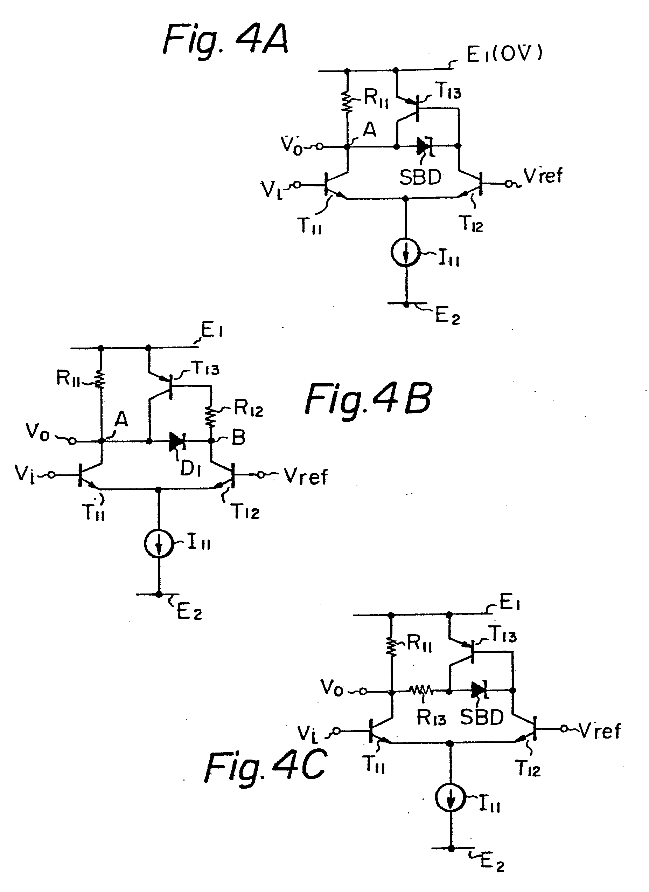

Such a current switch is shown in, for example, IEEE International Solid State Circuit Conference, Digest of Technical Papers, February 1976, page 189, Fig. 4.

As is known in the construction of bipolar transistors, the collector occupies a larger area than the emitter and establishes a large capacitance relative to the substrate. The capacitance Cc and the load resistor $R_1$ define a time constant which determines the rise speed of the collector potential. Accordingly, the rise speed of the output voltage $V_o$ from a low level to a high level is determined by the time constant. The collector potential is quickly switched from the high level to the low level, when the transistor $T_1$ is rendered conductive, if there is a small time constant determined by a small resistance while the transistor $T_1$ is conductive, and by the capacitance Cc. In order to increase the rise speed of the output voltage $V_o$, it has heretofore been attempted to reduce the load resistance $R_1$. However, the current must then be increased if it is desired to achieve the same collector voltage amplitude as before, e.g. for logic circuits.

The present invention is to provide a current switch which operates at high speeds by improving the rise characteristics in switching the output voltage from the low level to the high level, utilising a current at the transistor $T_2$ side. When the output voltage $V_o$ rises, the transistor $T_2$ on the reference side is rendered conductive and a wasteful electric current flows into the substrate. According to the present invention, however, it is contemplated to utilise the electric current effectively. Namely, the electric current is fed to the collector of the transistor $T_1$ to charge the collector capacitance $C_c$ of the transistor $T_1$. Consequently, the capacitance $C_c$ is charged more quickly, enabling the output voltage $V_o$ to rise quickly.

Fig. 2A illustrates an embodiment of the present invention. In the circuit of Fig. 2A, an emitter-base path of a pnp-type transistor $T_{13}$ is inserted between the collector of a transistor $T_{12}$ and a power supply line $E_1$, and the collector of the transistor $T_{13}$ is connected to the collector of a transistor $T_{11}$. The circuit is the same in other respects as that of Fig. 1. In Fig. 2A, symbol $E_2$ denotes a power supply line of negative polarity.

Operation of the circuit is as follows. When an input voltage $V_i$ is at a higher level than the reference voltage $V_{ref}$, the transistor $T_{11}$ is rendered conductive and the transistor $T_{12}$ non-conductive, and when the input voltage $V_i$ is at a lower level than the reference voltage $V_{ref}$, the transistor $T_{11}$ is rendered non-conductive and the transistor $T_{12}$ conductive, in the same manner as the circuit of Fig. 1. However, when the transistor $T_{11}$ is rendered non-conductive, i.e. when the output voltage $V_o$ rises, the transistor $T_{12}$ is rendered conductive, so that an electric current is allowed to flow into the transistor $T_{12}$ through the emitter-base path of the transistor $T_{13}$. The transistor $T_{13}$ is therefore rendered conductive, and a collector current is permitted to flow into the collector of the transistor $T_{11}$ which is rising. This helps to charge the collector capacitance of the transistor $T_{11}$. Hence, the collector capacitance is quickly charged, being assisted by the electric current which is introduced through the load resistor $R_{11}$, whereby the collector potential or, in other words, the output voltage, is quickly raised to the high level.

In the circuit shown in Fig. 2A, not only the electric charge stored in the collector capacitance of the transistor $T_{11}$, but also the charge stored in the collector capacitance of the transistor $T_{13}$, must be discharged when the transistor $T_{11}$ is rendered conductive, i.e. when the output voltage $V_o$ switches from the high level to the low level. However, the resistance of the transistor $T_{11}$ while it is conductive is so small that the discharge is quickly effected and the switching of the output voltage is not much delayed.

Fig. 2B illustrates a circuit which is capable of producing only a non-inverted output relative to the input voltage $V_i$. In this case, a load resistor $R_{11a}$ is connected between the transistor $T_{12}$ and the power supply $E_1$. An emitter-base path of a pnp-type transistor $T_{13a}$ is connected between the collector of the transistor $T_{11}$ and the power supply line $E_1$, and the collector of the transistor $T_{13a}$ is connected to the collector of the transistor $T_{12}$. The circuit is, in other respects, the same as that of Fig. 2A. The circuit also operates in the same manner as the circuit of Fig. 2A.

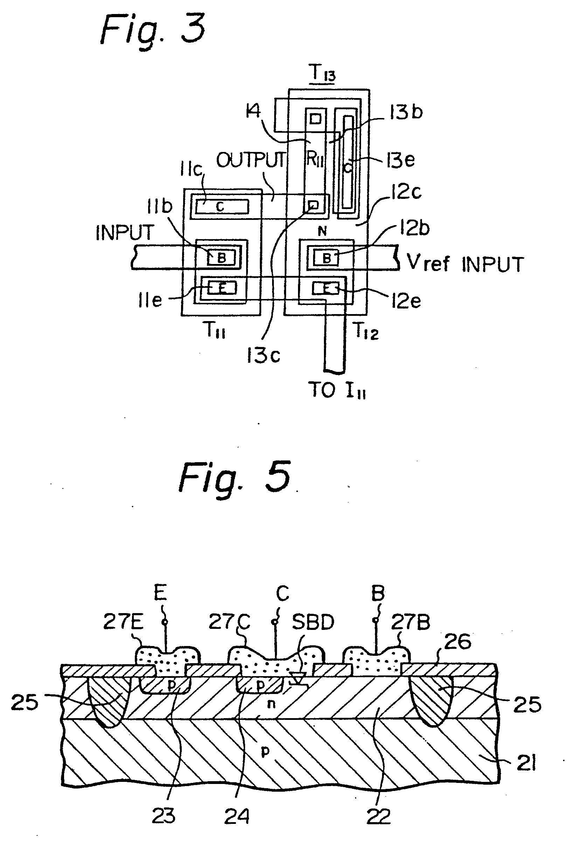

Fig. 3 is a plan view illustrating a circuit pattern of the circuit of Fig. 2A, in which reference numerals 11e, 11b and 11c denote the emitter, base and collector of the transistor $T_{11}$, respectively, reference numerals 12e, 12b and 12c denote the emitter, base and collector of the transistor $T_{12}$, respectively, and 13e, 13b and 13c denote the emitter, base and collector of the transistor $T_{13}$, respectively. Reference numerals 13c and 14 denote a $p^+$-type collector region and a diffusion resistance layer which are formed, being diffused in the base region 13b. In this configuration, transistor $T_{13}$ is constituted at the $p^+$-type collector region, the n-type layer 13b and the $p^+$-type emitter layer (lying on the n-type layer 13b) which is not illustrated. As the transistor $T_{13}$ and the resistor $R_{11}$ are both formed at the diffusion layer 14, the circuit of this pattern can be constructed in a small area without requiring wiring.

By the addition of the pnp-type transistor $T_{13}$ as shown in Figs. 2A and 2B, the rise characteristics of the output voltage $V_o$ of $\overline{V}_o$ can be improved without the need to decrease the load resistance $R_{11}$. With regard to the switching characteristics of the output voltage $V_o$, however, there still remains room for improvement. Namely, when the transistor $T_{11}$ is rendered conductive so that the output voltage $V_o$ switches from the high level to the low level, it is necessary to discharge not only the electric charge stored in the collector capacitance of the transistor $T_{11}$, but also to discharge the charge stored in the collector capacitance of the transistor $T_{13}$. Since the transistor $T_{11}$ in itself has a small resistance while it is conductive, it can be easily understood that the discharging is carried out quickly. In a steady state in which the transistor $T_{11}$ is non-conductive and the transistor $T_{12}$ is conductive, however, the potential between the resistor $R_{11}$ and a junction between the transistors $T_{11}$ and $T_{13}$ rises to nearly zero volts ($E_1$ is assumed to be 0 volt). On the other hand, the base potential of the transistor $T_{13}$ is at a value which is lower than the zero potential by an amount dropped across the pn emitter/base junction. In other words, the base potential of the transistor $T_{13}$ is at a value of about −0.8 volt. Consequently, a forward biasing voltage is applied across the collector and the base, so that the transistor $T_{13}$ is saturated. Accordingly, a large amount of charge is accumulated in the junction capacitance between the collector and the base of the transistor $T_{13}$. Extended periods of time are required to discharge the thus-accumulated electric charge. In effect, the switching of the output voltage $V_o$ tends to be delayed.

In order to eliminate the above-mentioned defect, an embodiment of the present invention provides a current switch in which the collector potential of the pnp-type transistor $T_{13}$ is clamped, so that it operates in an unsaturated region, in an attempt to reduce the collector capacitance and to improve the switching characteristics. This second embodiment of the present invention is as follows.

Fig. 4A illustrates an embodiment of the present invention employing a Schottky barrier diode SBD as a clamping diode. In this embodiment, the diode SBD is connected in the forward direction between the collector and the base of the transistor $T_{13}$. The circuit is otherwise the same as that of Fig. 2A. When the transistor $T_{12}$ is rendered conductive by the input $V_i$ at a low level, the base potential of the transistor $T_{13}$ is −0.8 volt, as mentioned earlier. In this case, the transistor $T_{11}$ remains non-conductive.

However, the provision of the diode SBD permits a portion of a constant current $I_{11}$ to flow through a path $E_1$, $R_{11}$, SBD and $T_{12}$, whilst the base current of the transistor $T_{13}$ flows in parallel therewith. Hence, the potential at the point A decreases below 0 volts due to the current which flows through the resistor $R_{11}$. This potential is, however, determined by the diode SBD. For example, if the voltage drop through the diode SBD in the forward direction is 0.4 volt, the potential at the point A is clamped to −0.4 volt which is higher than the base potential of −0.8 volt by 0.4 volt. With this circuit a voltage greater than the forward voltage (0.8 volt) is not applied across the collector and the base of the transistor $T_{13}$, and the transistor $T_{13}$ operates in an unsaturated region. Hence, a small amount of electric charge is accumulated in the collector capacitance and the switching characteristic is improved. When the input $V_i$ changes from the low level to the high level, the output rapidly switches from the high level to the low level (since the above-mentioned collector charge is quickly discharged).

Fig. 4B illustrates another embodiment of the present invention employing an ordinary pn-junction diode $D_1$ as a clamping diode. In this embodiment, the pn-junction diode $D_1$ is substituted for the Schottky barrier diode SBD of Fig. 4A, and a shifting resistor $R_{12}$ is inserted between the base of the transistor $T_{13}$ and the cathode (point B) of the diode $D_1$. The diode $D_1$ has a forward voltage of 0.8 volt, like the voltage across the collector and the base of the transistor $T_{13}$. If a pn-junction diode is used in the circuit of Fig. 4A in place of the diode SBD, it is difficult to prevent the transistor $T_{13}$ from being saturated. However, when the potential at the point B is lowered by inserting the resistor $R_{12}$ as shown in Fig. 4B, the potential at the point A is lowered correspondingly, making it possible to prevent the transistor $T_{13}$ from being saturated. For example, if the voltage is dropped by 0.4 volt by the resistor $R_{12}$, the potential at the point B becomes −1.2 volts, which is lower by 0.4 volt than −0.8 volt which is the base potential of the transistor $T_{13}$. Accordingly, even when the potential at the point A is clamped by the diode $D_1$ to −0.4 volt, which is higher by 0.8 volt than the potential at the point B, the same result is obtained as that of the circuit of Fig. 4A.

Fig. 4C illustrates yet a further embodiment of the present invention in which a resistor $R_{13}$ is inserted between the point A and the diode SBD of Fig. 4A, to increase the amplitude of the output $V_o$. When the output $V_o$ is at the high level, i.e. when the transistor $T_{12}$ is conductive, a current flows through a path $E_1$, $R_{11}$, $R_{13}$, SBD and $T_{12}$ so that the collector of the transistor $T_{13}$ is clamped to a desired potential due to the diode SBD. In this case, however, the potential at the point A does not decrease to the collector potential of the transistor $T_{13}$ owing to the current which flows through the resistor $R_{13}$. Accordingly, the output voltage $V_o$ is maintained at a high value. The resistor $R_{13}$ for increasing the amplitude can also be employed for the circuit of Fig. 4B.

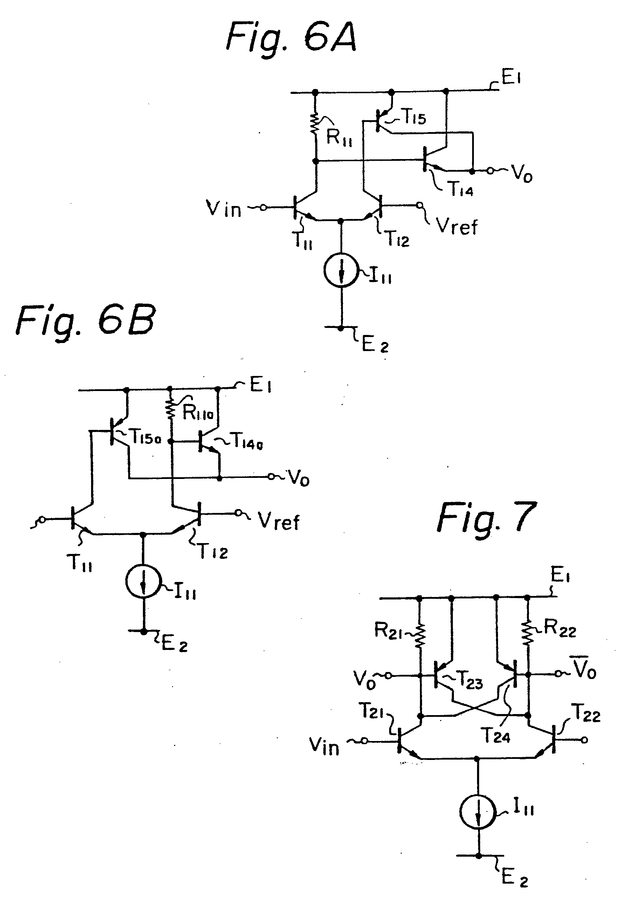

When the Schottky barrier diode is used as a clamping diode, the shifting resistor $R_{12}$ is not required, which enables the circuit to be simplified and has advantages from the standpoint of circuit construction. In general, however, it is difficult to provide the diode SBD in the pnp-type transistor to clamp its collector potential relative to the base potential. However, this can be easily realised if the transistor is formed in a lateral construction. Thus, Fig. 5 illustrates the construction of elements in which the pnp-type transistor $T_{13}$ (shown in Fig. 4A) and the Schottky barrier diode SBD (shown in Fig. 4A) are formed in the same land, wherein reference numeral 21 denotes a p-type silicon semiconductor substrate, 22 denotes an n-type layer which is formed on the surface of the substrate 21 and which serves as a base region, 23 and 24 denote a p-type emitter region and a p-type collector region, respectively, which are formed in the surface of the n-type layer 22, 25 denotes regions for isolating the elements, 26 denotes a surface insulation layer, and 27E, 27C and 27B denote an emitter, a collector and a base, respectively, which are in ohmic contact with the regions 22, 23 and 24, and which constitute the pnp-type transistor $T_{13}$. With this device, if the collector 27C is contacted to a portion of the n-type layer 22, there is established a Schottky barrier diode SBD, so that the circuit becomes equivalent to that of Fig. 4A.

Figs. 6A and 6B illustrate further embodiments of the invention, in which the outputs of the load resistors $R_{11}$ and $R_{11a}$ are produced via emitter-follower transistors $T_{14}$ and $T_{14a}$. The present invention is also applicable to the circuits of Figs. 6A and 6B, wherein symbols $T_{15}$ and $T_{15a}$ denote transistors for improving the rise characteristics of the output voltage.

Fig. 7 shows a circuit of the type having a binary output. It produces, from the collector of the transistor $T_{22}$, an output voltage (voltage $\overline{V}_o$) of a polarity opposite to that of the output voltage $V_o$. In this circuit, the pnp-type transistors are inserted on both sides to improve the rise characteristics of the two output voltages. Symbols $T_{23}$ and $T_{24}$ denote the pnp-type transistors, and $R_{21}$ and $R_{22}$ denote the load resistors. The circuit of Fig. 7 operates in the same manner as the circuits of Figs. 2A and 2B. However, since the load resistors $R_{21}$ and $R_{22}$ are inserted in parallel with the emitter-base paths of the transistors $T_{23}$ and $T_{24}$, respectively, the constant current $I_{11}$, when the transistors $T_{21}$ and $T_{22}$ are rendered conductive, is supplied in the form of a sum of currents flowing through the load resistors $R_{21}$, $R_{22}$ and base currents of the transistors $T_{23}$, $T_{24}$.

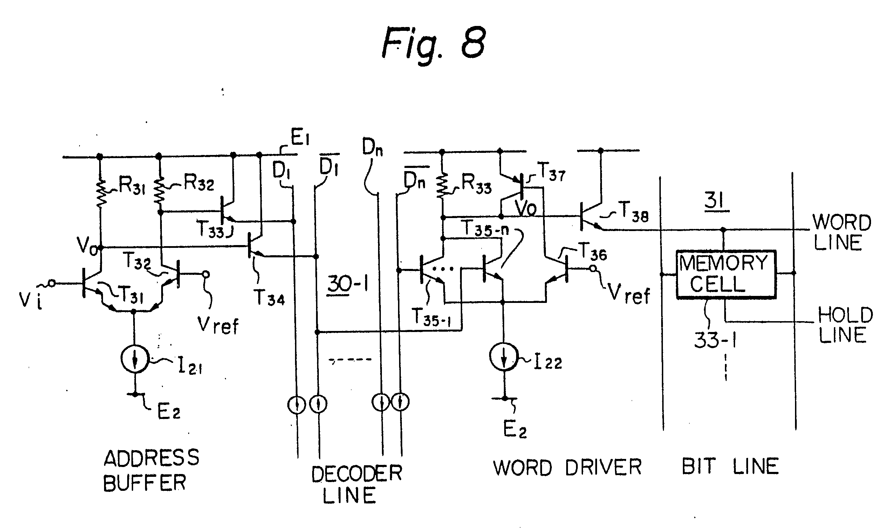

Finally, described below is an example of an application of the circuit of the present invention. Fig. 8 illustrates an application in which the circuit of the present invention is used in an address decoder of a memory. Referring to Fig. 8, an address input is fed to an address buffer consisting of transistors $T_{31}$ and $T_{32}$, and resistors $R_{31}$ and $R_{32}$. The output of the address buffer is fed to decoder lines 30-1 via level-shifting transistors $T_{33}$ and $T_{34}$. The output of the decoder 30-1 is fed to a memory cell 31 via a word driver, which is constructed in the form of a current switch according to the present invention and which is made up of transistors $T_{35-1}, \ldots T_{35-n}, T_{36}, T_{37}$ and a resistor $R_{33}$, and via a transistor $T_{38}$ for driving the word line. The output is then fed to the word line.

In the circuit of Fig. 8, the transistors $T_{35-1} \ldots T_{35-n}$ employed in the circuit of the present invention constitute an output stage for the address decoder. The output stage of the address decoder constitutes a current switch made up of the transistor $T_{36}$ to which will be applied a reference voltage, and a plurality of transistors which are connected in parallel and to which will be fed address signal bits selected from those consisting of $A_1, A_2, \ldots A_n$ and $\overline{A}_1, \overline{A}_2, \ldots \overline{A}_n$ which are of the inverted form. Here, the plurality of transistors is represented by $T_{35-1} \ldots T_{35-n}$. In the address decoder, when the signals selected from the signals $A_1, A_2, \ldots A_n$ are all at the low level, the transistors $T_{35-1} \ldots T_{35-n}$ are all rendered non-conductive, whereby the output voltage $V_o$ acquires the high level so that the word line becomes high level. However, the number of the transistors $T_{35-1} \ldots T_{35-n}$ increases with increase in the number $n$ of the address signal bits, and the speed at which the output voltages $V_o$ acquires the high level becomes slow, i.e. the speed for selecting the word lines becomes slow. Therefore, a transistor $T_{37}$ is inserted in the circuit of the transistor $T_{36}$ to temporarily feed collector current to the transistors $T_{35-1} \ldots T_{35-n}$ in order to charge the parasitic collector capacitances of the transistors $T_{35-1} \ldots T_{35-n}$. By so doing, the speed for selecting the word lines can be increased.

In the current switch of the present invention, as illustrated in detail in the foregoing, the collector capacitance of a transistor while it is non-conductive is electrically charged by a pnp-type transistor utilising the operation of another transistor while it is conductive, in order to improve the rise and switching characteristics of the output voltage. Consequently, the circuit of the present invention can be very effectively employed for, for example, logic circuits and memory decoders.

## Claims

1. An electronic current switch circuit in which the emitters of first and second transistors are connected in common to a constant-current supply, and a load resistor is connected to the collector of the first transistor to provide an output from the collector, characterised in that a third transistor ($T_{13}, T_{13a}$) in which an electric current temporarily flows to a collector circuit of the first transistor ($T_{11}, T_{12}$) when said first transistor is rendered non-conductive, is connected in a collector circuit of the second transistor ($T_{12}, T_{11}$).

2. A circuit according to Claim 1, characterised in that said third transistor ($T_{13}, T_{13a}$) is a PNP transistor.

3. A circuit according to Claim 2, characterised in that the load resistor ($R_{11}, R_{11a}$) is connected between the collector of the first transistor ($T_{11}, T_{12}$) and a power supply ($E_1$), the base and emitter of the third transistor ($T_{13}, T_{13a}$) are connected between the collector of the second transistor ($T_{12}, T_{11}$) and the power supply, the collector of the third transistor is connected to a connection point between the collector of the first transistor and the load resistor, an input voltage ($V_I$) is applied to the base of the first or the second transistor, a reference voltage ($V_{ref}$) is applied to the base of the second or the first transistor, respectively, and an output ($V_o, \overline{V}_o$) is taken from the collector of the first transistor.

4. A circuit according to Claim 2 or Claim 3, characterised in that a Schottky barrier diode (SBD) is connected across the base/collector junction of the third transistor ($T_{13}$).

5. A circuit according to Claim 4, characterised in that a resistor ($R_{13}$, Fig. 4C) is connected between the collector of the first tran-

sistor ($T_{11}$) and a connection point which connects the collector of the third transistor ($T_{13}$) and the Schottky barrier diode (SBD).

6. A circuit according to Claim 3, characterised in that the base of the third transistor ($T_{13}$) is connected to the collector of the second transistor ($T_{12}$) via a resistor ($R_{12}$), and a diode ($D_1$) is connected between the collector of the third transistor ($T_{13}$) and the collector of the second transistor ($T_{12}$).

7. A circuit according to Claim 1 or Claim 2, characterised in that the collector circuit of the first transistor ($T_{11}$) comprises a load resistor ($R_{11}$) which is connected between the collector of the first transistor and a power supply ($E_1$), and a fourth transistor ($T_{14}$) of the emitter-follower type the base of which is connected to the junction of the load resistor and the first transistor, the collector of the fourth transistor being connected to the power supply, and the emitter serving as an output terminal ($V_0$); in that the base/emitter circuit of the third transistor ($T_{15}$) is connected between the collector of the second transistor ($T_{12}$) and the power supply; in that the collector of the third transistor is connected to the emitter of said fourth transistor; and in that an input voltage ($V_{in}$) is applied to the base of the first transistor, a reference voltage ($V_{ref}$) is applied to the base of the second transistor, and an output ($V_0$) is obtained from the emitter of the fourth transistor.

8. A circuit according to Claim 1 or Claim 2, characterised by a fourth transistor ($T_{14a}$) of the emitter-follower type of which the base is connected to the junction between the load resistor and the first transistor ($T_{12}$) of which the collector is connected to the power supply and of which the emitter serves as an output terminal ($V_0$); in that the base/emitter circuit of the third transistor ($T_{15a}$) is connected between the collector of the second transistor ($T_{11}$) and the power supply, the collector of the third transistor is connected to the emitter of the fourth transistor; and in that an input voltage is applied to the base of the second transistor, a reference voltage is applied to the base of the first transistor, and an output is taken out from the emitter of the fourth transistor.

9. A circuit according to Claim 3, characterised in that the first transistor is one of a group of transistors ($T_{35-1} \ldots T_{35-n}$) which are connected in parallel with each other, a load resistor ($R_{33}$) is connected between the collectors of the group of transistors and the power supply ($E_1$), the base/emitter circuit of the third transistor ($T_{37}$) is connected between the collector of the second transistor ($T_{36}$) and the power supply, the collector of the third transistor is connected to a connection point between the collectors of the group of transistors and the load resistor; and in that respective input voltages are applied to the bases of the group of transistors, a reference voltage is applied to the base of the second transistor, and an output is taken from the connection point between the collectors of the group of transistors and the load resistor.

## Patentansprüche

1. Elektronischer Schaltkreis, bei welchem die Emitter des ersten und des zweiten Transistors gemeinsam mit einer Konstantstromquelle verbunden sind und ein Lastwiderstand mit dem Kollektor des ersten Transistors verbunden ist, um einen Ausgang des Kollektors zu liefern, dadurch gekennzeichnet, daß ein dritter Transistor ($T_{13}$, $T_{13a}$), in welchem zeitweise ein elektrischer Strom zu dem Kollektorkreis des ersten Transistors ($T_{11}$, $T_{12}$) fließt, wenn der genannte erste Transistor gesperrt ist, mit dem Kollektorkreis des zweiten Transistors ($T_{12}$, $T_{11}$) verbunden ist.

2. Schaltkreis nach Anspruch 1, dadurch gekennzeichnet, daß der genannte dritte Transistor ($T_{13}$, $T_{13a}$) ein PNP-Transistor ist.

3. Schaltkreis nach Anspruch 2, dadurch gekennzeichnet, daß der Lastwiderstand ($R_{11}$, $R_{11a}$) zwischen den Kollektor des ersten Transistors ($T_{11}$, $T_{12}$) und einer Stromversorgung ($E_1$) geschaltet ist, daß Basis und Emitter des dritten Transistors ($T_{13}$, $T_{13a}$) zwischen dem Kollektor des zweiten Transistors ($T_{12}$, $T_{11}$) und der Stromversorgung geschaltet sind, daß der Kollektor des dritten Transistors mit einem Koppelpunkt zwischen dem Kollektor des ersten Transistors und dem Lastwiderstand geschaltet ist, daß eine Eingangsspannung ($V_i$) der Basis des ersten oder zweiten Transistors zugeführt wird, daß eine Referenzspannung ($V_{ref}$) der Basis des zweiten bzw. ersten Transistors zugeführt wird und daß von dem Kollektor des ersten Transistors ein Ausgang ($V_0$, $\overline{V}_0$) abgegriffen wird.

4. Schaltkreis nach Anspruch 2 oder 3, dadurch gekennzeichnet, daß eine Schottky-Diode (SBD) quer über den Basis/Kollektor-Übergang des dritten Transistors ($T_{13}$) geschaltet ist.

5. Schaltkreis nach Anspruch 4, dadurch gekennzeichnet, daß ein Widerstand ($R_{13}$, Fig. 4C) zwischen dem Kollektor des ersten Transistors ($T_{11}$) und einem Verbindungspunkt geschaltet ist, welcher den Kollektor des dritten Transistors ($T_{13}$) und die Schottky-Diode (SBD) miteinander verbindet.

6. Schaltkreis nach Anspruch 3, dadurch gekennzeichnet, daß die Basis des dritten Transistors ($T_{13}$) mit dem Kollektor des zweiten Transistors ($T_{12}$) über einen Widerstand ($R_{12}$) verbunden und daß eine Diode ($D_1$) zwischen den Kollektor des dritten Transistors ($T_{13}$) und den Kollektor des zweiten Transistors ($T_{12}$) geschaltet ist.

7. Schaltkreis nach Anspruch 1 oder 2, dadurch gekennzeichnet, daß der Kollektorkreis des ersten Transistors ($T_{11}$) einen Lastwiderstand ($R_{11}$), welcher zwischen den Kollektor des ersten Transistors und der Strom-

versorgung ($E_1$) geschaltet ist, und einen vierten Transistor ($T_{14}$) vom Emitterfolgetyp umfaßt, dessen Basis mit dem Koppelpunkt des Lastwiderstands und des ersten Transistors verbunden ist, dessen Kollektor mit der Stromversorgung verbunden ist und dessen Emitter als Ausgangsanschluß ($V_o$) dient, daß der Basis/Emitterkreis des dritten Transistors ($T_{15}$) zwischen den Kollektor des zweiten Transistors ($T_{12}$) und der Stromversorgung geschaltet ist, daß der Kollektor des dritten Transistors mit dem Emitter des vierten Transistors verbunden ist, und daß eine Eingangsspannung ($V_{in}$) der Basis des ersten Transistors zugeführt wird, eine Referenzspannung ($V_{ref}$) der Basis des zweiten Transistors zugeführt wird und eine Ausgangsspannung ($V_o$) an dem Emitter des vierten Transistors erzielt wird.

8. Schaltkreis nach Anspruch 1 oder 2, dadurch gekennzeichnet, daß ein vierter Transistor ($T_{14a}$) vom Emitterfolgetyp vorgesehen ist, dessen Basis mit dem Koppelpunkt des Lastwiderstands und des ersten Transistors ($T_{12}$) verbunden ist, dessen Kollektor mit der Stromversorgung verbunden ist und dessen Emitter als Ausgangsanschluß ($V_o$) dient, daß der Basis/Emitter-Kreis des dritten Transistors ($T_{15a}$) zwischen den Kollektor des zweiten Transistors ($T_{11}$) und der Stromversorgung geschaltet ist, während der Kollektor des dritten Transistors mit dem Emitter des vierten Transistors verbunden ist, und daß eine Eingangsspannung der Basis des zweiten Transistors zugeführt, eine Referenzspannung der Basis des ersten Transistors zugeführt, und ein Ausgang am Emitter des vierten Transistors abgegriffen werden.

9. Schaltkreis nach Anspruch 3, dadurch gekennzeichnet, daß der erste Transistor einer der Gruppe von Transistoren ($T_{35-1} \ldots T_{35-n}$) ist, welche parallel zueinander geschaltet sind, daß ein Lastwiderstand ($R_{33}$) zwischen den Kollektoren der Gruppe von Transistoren und der Stromversorgung ($E_1$) geschaltet ist, daß der Basis/Emitter-Kreis des dritten Transistors ($T_{37}$ zwischen dem Kollektor des zweiten Transistors ($T_{36}$ und der Stromversorgung geschaltet ist, daß der Kollektor des dritten Transistors mit einem Koppelpunkt zwischen den Kollektoren der Gruppe von Transistoren und dem Lastwiderstand verbunden ist, und daß die jeweiligen Eingangsspannungen den Basen der Gruppe von Transistoren zugeführt werden, daß eine Referenzspannung der Basis des zweiten Transistors zugeführt wird und daß ein Ausgang am Koppelpunkt zwischen den Kollektoren der Gruppe von Transistoren und dem Lastwiderstand abgegriffen wird.

**Revendications**

1. Circuit commutateur de courant électronique dans lequel les émetteurs d'un premier et d'un deuxième transistor sont connectés en commun à une alimentation en courant constant, et une résistance de charge est connectée au collecteur du premier transistor afin de produire un signal de sortie provenant du collecteur, caractérisé en ce qu'un troisième transistor ($T_{13}$, $T_{13a}$), dans lequel un courant électrique circule temporairement à destination d'un circuit de collecteur du premier transistor ($T_{11}$, $T_{12}$) lorsque le premier transistor est rendu non conducteur, est connecté dans un circuit de collecteur du deuxième transistor ($T_{12}$, $T_{11}$).

2. Circuit selon la revendication 1, caractérisé en ce que ledit troisième transistor ($T_{13}$, $T_{13a}$) est un transistor PNP.

3. Circuit selon la revendication 2, caractérisé en ce que la résistance de charge ($R_{11}$, $R_{11a}$) est connectée entre le collecteur du premier transistor ($T_{11}$, $T_{12}$) et une alimentation électrique ($E_1$), la base et l'émetteur du troisième transistor ($T_{13}$, $T_{13a}$) sont connectés entre le collecteur du deuxième transistor ($T_{12}$, $T_{11}$) et l'alimentation électrique, le collecteur du troisième transistor est connecté à un point de connexion situé entre le collecteur du premier transistor et la résistance de charge, une tension d'entrée ($V_i$) est appliquée à la base du premier ou du deuxième transistor, une tension de référence ($V_{ref}$) est appliquée à la base du deuxième ou du troisième transistor, respectivement, et un signal de sortie ($V_o$, $\bar{V}_o$) est prélevé sur le collecteur du premier transistor.

4. Circuit selon la revendication 2 ou 3, caractérisé en ce qu'une diode à barrière de Schottky (SBD) est connectée sur la jonction base-collecteur du troisième transistor ($T_{13}$).

5. Circuit selon la revendication 4, caractérisé en ce qu'une résistance ($R_{13}$, figure 4c) est connectée entre le collecteur du premier transistor ($T_{11}$) et un point de connexion qui relie le collecteur du troisième transistor ($T_{13}$) et la diode à barrière de Schottky (SBD).

6. Circuit selon la revendication 3, caractérisé en ce que la base du troisième transistor ($T_{13}$) est connectée au collecteur du deuxième transistor ($T_{12}$) via une résistance ($R_{12}$), et une diode ($D_1$) est connectée entre le collecteur du troisième transistor ($T_{13}$) et le collecteur du deuxième transistor ($T_{12}$).

7. Circuit selon la revendication 1 ou 2, caractérisé en ce que le circuit de collecteur du premier transistor ($T_{11}$) comprend une résistance de charge ($R_{11}$) qui est connectée entre le collecteur du premier transistor et une alimentation électrique ($E_1$), et une quatrième transistor ($T_{14}$) du type à émetteur suiveur dont la base est connectée à la jonction de la résistance de charge et du premier transistor, le collecteur du quatrième transistor étant connecté à l'alimentation électrique, et l'émetteur faisant fonction de borne de sortie ($V_o$); en ce que le circuit base-émetteur du troisième transistor ($T_{15}$) est connecté entre le collecteur du deuxième transistor ($T_{12}$) et l'alimentation électrique; en ce que le collecteur du troisième transistor est connecté à l'émetteur dudit quatrième transistor; et en ce qu'une tension d'entrée ($V_{in}$) est appliquée à la base du premier transistor, une tension de référence ($V_{ref}$) est appliquée à la base du deuxième transistor, et un signal de sortie ($V_o$) est obtenu sur l'émetteur du quatrième transistor.

8. Circuit selon la revendication 1 ou 2, caractérisé par un quatrième transistor ($T_{14a}$) du type à émetteur suiveur dont la base est connectée à la jonction entre la résistance de charge et le premier transistor ($T_{12}$), dont le collecteur est connecté à l'alimentation électrique et dont l'émetteur fait fonction de borne de sortie ($V_o$); en ce que le circuit base-émetteur de troisième transistor ($T_{15a}$) est connecté entre le collecteur du deuxième transistor ($T_{11}$) et de l'alimentation électrique, le collecteur du troisième transistor est connecté à l'émetteur du quatrième transistor; et en ce qu'une tension d'entrée est appliquée à la base du deuxième transistor, une tension de référence est appliquée à la base du premier transistor, et un signal de sortie est prélevé sur l'émetteur du quatrième transistor.

9. Circuit selon la revendication 3, caractérisé en ce que le premier transistor appartient à un groupe de transistors ($T_{35-1}, \ldots T_{35-n}$) qui sont connectés mutuellement en parallèle, une résistance de charge ($R_{33}$) est connectée entre les collecteur du groupe de transistors et l'alimentation électrique ($E_1$), le circuit base-émetteur du troisième transistor ($T_{37}$) est connecté entre le collecteur du deuxième transistor ($T_{36}$) et l'alimentation électrique, le collecteur du troisième transistor est connecté à un point de connexion entre les collecteurs du groupe de transistors et la résistance de charge; et en ce que des tensions d'entrée respectives sont appliquées aux bases du groupe de transistors, une tension de référence est appliquée à la base du deuxième transistor, et un signal de sortie est prélevé sur le point de connexion entre les collecteurs du groupe de transistors et la résistance de charge.

# Fig. 1

# Fig. 2A

# Fig. 2B

1

*Fig. 3*

T₁₃

14

13b

R₁₁

13e

OUTPUT

11c

C

12c

11b

N

12b

INPUT

B

B

Vref INPUT

11e

E

E

12e

T₁₁

T₁₂

13c

TO I₁₁

*Fig. 5.*

E

C

B

27E

27C

SBD

27B

26

p

p

n

25

25

n

p

21

23

24

22

Fig. 4A

Fig.4B

Fig.4C

# Fig. 6A

# Fig. 6B

# Fig. 7

4

# Fig. 8

ADDRESS BUFFER   DECODER LINE   WORD DRIVER   BIT LINE

0018172